(19) Europäisches Patentamt
European Patent Office
Office européen des brevets

(11) **EP 4 421 508 A1**

(12) **EUROPEAN PATENT APPLICATION**

(43) Date of publication:
**28.08.2024 Bulletin 2024/35**

(21) Application number: **24158581.9**

(22) Date of filing: **20.02.2024**

(51) International Patent Classification (IPC):
**G01R 33/00** (2006.01)    **G01R 33/025** (2006.01)

(52) Cooperative Patent Classification (CPC):
**G01R 33/0029; G01R 33/007; G01R 33/0094; G01R 33/025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.02.2023 JP 2023027555**

(71) Applicant: **TDK Corporation**
**Tokyo 103-6128 (JP)**

(72) Inventors:
• **KURISU, Masafumi**
**Tokyo, 103-6128 (JP)**
• **AKUSHICHI, Taiju**
**Tokyo, 103-6128 (JP)**
• **SEKIHARA, Kensuke**
**Tokyo, 190-0031 (JP)**

(74) Representative: **Epping - Hermann - Fischer Patentanwaltsgesellschaft mbH**
**Schloßschmidstraße 5**
**80639 München (DE)**

(54) **INFORMATION PROCESSING DEVICE, MEASUREMENT SYSTEM, AND PROGRAM**

(57)    Provided is an information processing device capable of improving the accuracy of removing noise from a result of measuring a desired signal when a plurality of reference sensors are used. An information processing device includes an acquisition unit configured to acquire signal measurement results of one or more signal sensors for measuring a mixed signal in which an objective signal and noise are mixed and noise measurement results of a plurality of reference sensors for measuring the noise and a signal processing unit configured to divide the signal measurement results and the noise measurement results acquired by the acquisition unit into a plurality of frequency bands for each of a plurality of division segments in a time domain and perform signal processing for removing the noise included in the mixed signal.

FIG. 1

**Description**

CROSS-REFERENCE TO RELATED APPLICATION

Priority is claimed on Japanese Patent Application No. 2023-027555, filed February 24, 2023, the content of which is incorporated herein by reference.

BACKGROUND OF THE INVENTION

Field of the Invention

The present disclosure relates to an information processing device, a measurement system, and a program.

Description of Related Art

In order to obtain good analysis results in various types of measurement, it is necessary to remove various types of environmental noise superimposed on a desired signal.
In general, as a method of removing environmental noise, a method of providing a reference sensor separately from a signal sensor for measuring the desired signal and filtering data acquired by the reference sensor in time series is used.
If there are many types of environmental noise, it is necessary to increase the number of reference sensors in correspondence therewith.
The magnetic field measurement device described in Patent Document 1 includes a magnetic shielding room, a magnetic sensor arranged inside of the magnetic shielding room, a reference magnetic sensor arranged outside of the magnetic shielding room, and a calculation device to which magnetic field time-series data from the magnetic sensor and environmental magnetic field time-series data from the reference magnetic sensor are input. The calculation unit obtains a magnitude of an environmental magnetic field included in the magnetic field time-series data to minimize a predetermined evaluation function of the magnetic field time-series data and estimated environmental magnetic field time-series data obtained from the environmental magnetic field time-series data and applies a magnetic field reduction effect to the environmental magnetic field time-series data for each frequency of the magnetic shielding room in obtaining the estimated environmental magnetic field time-series data (See Patent Document 1).

[Patent Documents]

[Patent Document 1] Japanese Unexamined Patent Application, First Publication No. 2019-10483

SUMMARY OF THE INVENTION

However, in the conventional technology, the accuracy of removing noise from a result of measuring a desired signal may be insufficient when a plurality of reference sensors are used.
The present disclosure has been made in consideration of such circumstances and an objective of the present disclosure is to provide an information processing device, a measurement system, and a program capable of improving the accuracy of removing noise from a result of measuring a desired signal when a plurality of reference sensors are used.
According to an aspect, there is provided an information processing device including: an acquisition unit configured to acquire signal measurement results of one or more signal sensors for measuring a mixed signal in which an objective signal and noise are mixed and noise measurement results of a plurality of reference sensors for measuring the noise; and a signal processing unit configured to divide the signal measurement results and the noise measurement results acquired by the acquisition unit into a plurality of frequency bands for each of a plurality of division segments in a time domain and perform signal processing for removing the noise included in the mixed signal.
According to an aspect, there is provided a measurement system including the information processing device, the signal sensors, and the reference sensors.
According to an aspect, there is provided a program for causing a computer to implement: an acquisition function of acquiring signal measurement results of one or more signal sensors for measuring a mixed signal in which an objective signal and noise are mixed and noise measurement results of a plurality of reference sensors for measuring the noise; and a signal processing function of dividing the signal measurement results and the noise measurement results acquired in the acquisition function into a plurality of frequency bands for each of a plurality of division segments in a time domain and performing signal processing for removing the noise included in the mixed signal.
According to the present disclosure, in an information processing device, a measurement system, and a program, it is possible to improve the accuracy of removing noise from a result of measuring a desired signal when a plurality of reference sensors are used.

BRIEF DESCRIPTION OF THE DRAWINGS

FIG. 1 is a diagram showing a schematic configuration of a measurement system including an information processing device according to an embodiment.
FIG. 2 is a diagram showing a schematic configuration of the information processing device according to the embodiment.
FIG. 3 is a diagram showing an example of segment division according to the embodiment.
FIG. 4A is a diagram showing a comparative example of environmental noise suppression results in a frequency domain according to the embodiment.
FIG. 4B is a diagram showing an example of a signal waveform in the case of M = 1 according to the embodiment.
FIG. 4C is a diagram showing an example of a signal waveform in the case of M = 2 according to the embodiment.
FIG. 4D is a diagram showing an example of a signal waveform in the case of M = 4 according to the embodiment.
FIG. 4E is a diagram showing an example of a signal waveform in the case of M = 8 according to the embodiment.
FIG. 4F is a diagram showing an example of a signal waveform in the case of M = 20 according to the embodiment.
FIG. 4G is a diagram showing an example of a signal waveform of an original signal according to the embodiment.
FIG. 4H is a diagram showing an example of a signal waveform of an original signal according to the embodiment.
FIG. 5A is a diagram showing an example in which environmental noise removal results in the frequency domain are compared according to the embodiment.
FIG. 5B is a diagram showing an example of a signal waveform in the case of Tw = 1k according to the embodiment.
FIG. 5C is a diagram showing an example of a signal waveform in the case of Tw = 6k according to the embodiment.
FIG. 5D is a diagram showing an example of a signal waveform in the case of Tw = 10k according to the embodiment.
FIG. 5E is a diagram showing an example of a signal waveform in the case of Tw = 20k according to the embodiment.
FIG. 5F is a diagram showing an example of a signal waveform in the case of Tw = 40k according to the embodiment.
FIG. 6A is a diagram showing an example in which environmental noise removal results in the frequency domain are compared according to the embodiment.
FIG. 6B is a diagram showing an example of a signal waveform in the case of $y = 1e^{-5}$ and Tw = 1k according to the embodiment.
FIG. 6C is a diagram showing an example of a signal waveform in the case of $y = 1e^{-5}$ and Tw = 10k according to the embodiment.
FIG. 6D is a diagram showing an example of a signal waveform in the case of $y = 1e^{-5}$ and Tw = 20k according to the embodiment.
FIG. 6E is a diagram showing an example of a signal waveform in the case of $y = 1e^{-5}$ and Tw = 40k according to the embodiment.
FIG. 6F is a diagram showing an example of a signal waveform in the case of $y = 1e^{-4}$ and Tw = 1k according to the embodiment.
FIG. 6G is a diagram showing an example of a signal waveform in the case of $y = 1e^{-4}$ and Tw = 10k according to the embodiment.
FIG. 6H is a diagram showing an example of a signal waveform in the case of $y = 1e^{-4}$ and Tw = 20k according to the embodiment.
FIG. 6I is a diagram showing an example of a signal waveform in the case of $y = 1e^{-4}$ and Tw = 40k according to the embodiment.
FIG. 6J is a diagram showing an example of a signal waveform in the case of $y = 1e^{-3}$ and Tw = 1k according to the embodiment.
FIG. 6K is a diagram showing an example of a signal waveform in the case of $y = 1e^{-3}$ and Tw = 10k according to the embodiment.
FIG. 6L is a diagram showing an example of a signal waveform in the case of $y = 1e^{-3}$ and Tw = 20k according to the embodiment.
FIG. 6M is a diagram showing an example of a signal waveform in the case of $\gamma = 1e^{-3}$ and Tw = 40k according to the embodiment.
FIG. 6N is a diagram showing an example of a signal waveform in the case of $y = 1e^{-2}$ and Tw = 1k according to the embodiment.
FIG. 6O is a diagram showing an example of a signal waveform in the case of $y = 1e^{-2}$ and Tw = 10k according to the embodiment.

FIG. 6P is a diagram showing an example of a signal waveform in the case of $\gamma$ = 1e$^{-2}$ and Tw = 20k according to the embodiment.

FIG. 6Q is a diagram showing an example of a signal waveform in the case of y = 1e$^{-2}$ and Tw = 40k according to the embodiment.

FIG. 7 is a diagram showing an example in which environmental noise removal results at noise densities are compared according to the embodiment.

FIG. 8 is a diagram showing an example of a processing procedure performed in the information processing device according to the embodiment.

FIG. 9 is a diagram showing another example of the processing procedure performed in the information processing device according to the embodiment.

## DETAILED DESCRIPTION OF THE INVENTION

Hereinafter, embodiments of the present disclosure will be described with reference to the drawings.

[Measurement system]

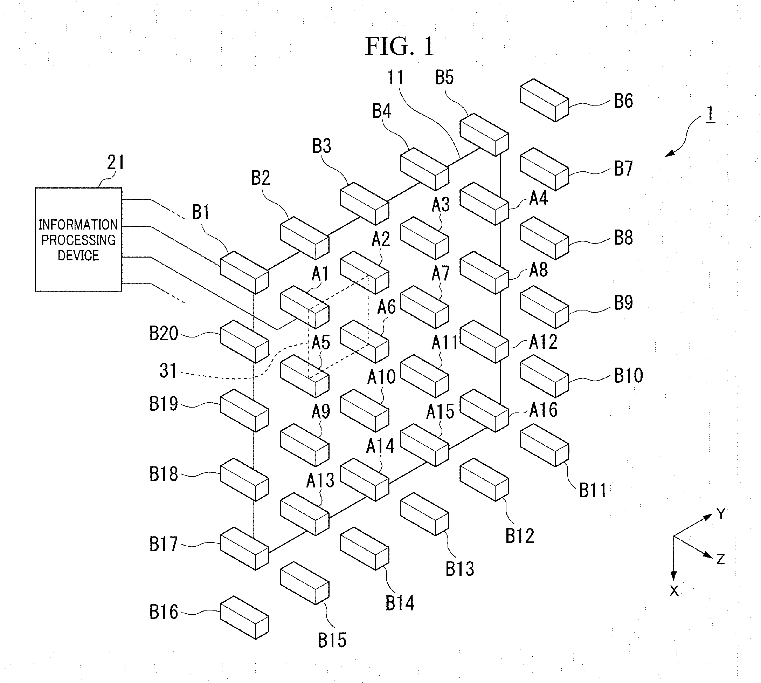

FIG. 1 is a diagram showing a schematic configuration of a measurement system 1 including the information processing device 21 according to the embodiment.

In FIG. 1, an XYZ Cartesian coordinate system, which is a three-dimensional Cartesian coordinate system, is shown for convenience of description.

The measurement system 1 includes L signal sensors A1 to AL, which are two or more signal sensors, M reference sensors B1 to BM, which are two or more reference sensors, and an information processing device 21.

In the example of FIG. 1, a region where the signal sensors A1 to AL are arranged is schematically shown as the signal sensor arrangement unit 11.

Here, in the present embodiment, as an example, the case of L = 16 and M = 20 will be described.

In addition, the number of signal sensors A1 to AL may be any number of 2 or more. Although a plurality of signal sensors A1 to AL are shown in the present embodiment, the number of signal sensors may be one.

Also, the number of reference sensors B1 to BM may be any number of 2 or more.

In FIG. 1, a measurement target 31 is also shown.

The measurement target 31 is not included in, for example, the measurement system 1 here, but may be regarded as included in the measurement system 1 as another example.

As the measurement target 31, any target may be used or, for example, all or a part of a living organism may be used. As a specific example, a human heart, a human brain, or the like may be used as the measurement target 3 1.

In addition, when a plurality of signal sensors A1 to AL are present, for example, a device (for example, a measurement device or the like) integrally including the plurality of signal sensors A1 to AL may be configured.

Also, when a plurality of reference sensors B1 to BM are present, for example, a device (for example, a noise measurement device or the like) integrally including the plurality of reference sensors B1 to BM may be configured.

Also, as another example, a device (for example, a measurement device or the like) integrally including all of the signal sensors A1 to AL and the reference sensors B1 to BM may be configured.

<Arrangement of signal sensors>

In the example of FIG. 1, the signal sensor arrangement unit 11 is a square planar region parallel to an XY plane.

In the example of FIG. 1, 16 signal sensors A1 to A16 are arranged at equal intervals in a direction parallel to one side of the square (a direction parallel to an X-axis) and at equal intervals in a direction perpendicular to the direction (a direction parallel to a Y-axis) inside of the signal sensor arrangement unit 11.

Specifically, the four signal sensors A1 to A4 are arranged at equal intervals in a direction parallel to the Y-axis, the four signal sensors A5 to A8 are arranged at equal intervals in a direction parallel to the Y-axis, the four signal sensors A9 to A12 are arranged at equal intervals in a direction parallel to the Y-axis, and the four signal sensors A13 to A16 are arranged at equal intervals in a direction parallel to the Y-axis.

Also, the four signal sensors A1, A5, A9, and A13 are arranged at equal intervals in a direction parallel to the X-axis, the four signal sensors A2, A6, A10, and A14 are arranged at equal intervals in a direction parallel to the X-axis, the four signal sensors A3, A7, A11, and A15 are arranged at equal intervals in a direction parallel to the X-axis, and the four signal sensors A4, A8, A12, and A16 are arranged at equal intervals in a direction parallel to the X-axis.

In the example of FIG. 1, the equal interval in the direction parallel to the X-axis and the equal interval in the direction parallel to the Y-axis are the same interval. In the example of FIG. 1, the plurality of signal sensors A1 to AL are arranged in an array.

Here, a form of the arrangement (overall arrangement) of the signal sensors A1 to AL is not particularly limited, and other forms may be used.

Also, the arrangement (for example, positions and directions) of the signal sensors A1 to AL is not particularly limited, and various forms may be used. For example, although the directions of the signal sensors A1 to AL are shown as the same direction in the example of FIG. 1, the direction of each of the signal sensors A1 to AL may be arbitrary.

In addition, the name of the signal sensor is a name for description and it may be referred to by another name such as a measurement sensor or (simply) a sensor.

<Arrangement of measurement target>

In the example of FIG. 1, when the deviation of the position parallel to the Z-axis is ignored and projection onto the XY plane is performed, the measurement target 31 is arranged at the center of the signal sensor arrangement unit 11 (or near the center thereof).

Here, a form of the arrangement relationship between the measurement target 31 and the signal sensors A1 to AL is not particularly limited, and other forms may be used.

<Objective signal>

In the signal sensors A1 to AL, a desired signal (also referred to as an objective signal for convenience of description) from the measurement target 31 is a target of measurement (detection). At this time, noise is superimposed on the objective signal. Thus, the signal sensors A1 to AL measure (detect) a signal in which the objective signal and the noise are mixed (also referred to as a mixed signal for convenience of description). Also, the signal sensors A1 to AL obtain their measurement results (also referred to as signal measurement results for convenience of description).

As the objective signal, a signal of any physical quantity may be used. For example, a signal such as magnetism, current, voltage, sound, or light may be used.

Also, as the objective signal, for example, a signal (biological signal) issued from a living body may be used or a signal issued from a physical object other than a living body may be used.

As a specific example, when the measurement target 31 is a human heart, a magnetic signal (magnetocardiogram signal) or an electrical signal (electrocardiogram signal) may be used as the objective signal. As another specific example, when the measurement target 31 is a human brain, a magnetic signal may be used as the objective signal.

<Arrangement of reference sensors>

In the example of FIG. 1, the reference sensors B1 to B20 are arranged to surround the periphery of the signal sensor arrangement unit 11.

Specifically, six reference sensors B1 to B6 are arranged at equal intervals in a direction parallel to the Y-axis on the negative side in a direction parallel to the X-axis with respect to the signal sensor arrangement unit 11.

Also, six signal sensors B6 to B11 are arranged at equal intervals in a direction parallel to the X-axis on the positive side in the direction parallel to the Y-axis with respect to the signal sensor arrangement unit 11.

Also, six signal sensors B11 to B16 are arranged at equal intervals in a direction parallel to the Y-axis on the positive side in the direction parallel to the X-axis with respect to the signal sensor arrangement unit 11.

Also, six signal sensors B16 to B20 and B1 are arranged at equal intervals in the direction parallel to the X-axis on the negative side in the direction parallel to the Y-axis with respect to the signal sensor arrangement unit 11.

In the example of FIG. 1, the equal interval in the direction parallel to the X-axis and the equal interval in the direction parallel to the Y-axis are the same interval. In the example of FIG. 1, a plurality of reference sensors B1 to BM are arranged in the vicinity of the signal sensors A1 to AL.

In the example of FIG. 1, the four reference sensors B2 to B5 parallel to the Y-axis are arranged at the same positions on the Y-axis as the four signal sensors A1 to A4 parallel to the Y-axis.

Likewise, the four reference sensors B12 to B15 parallel to the Y-axis are arranged at the same positions on the Y-axis as the four signal sensors A4, A3, A2, and A1 parallel to the Y-axis.

Also, in the example of FIG. 1, the four reference sensors B7 to B10 parallel to the X-axis are arranged at the same positions on the X-axis as the four signal sensors A1, A5, A9, and A13 parallel to the X-axis.

Likewise, the four reference sensors B17 to B20 parallel to the X-axis are arranged at the same position on the X-axis as the four signal sensors A13, A9, A5, and A1 parallel to the X-axis.

Here, a form of the arrangement (overall arrangement) of the plurality of reference sensors B1 to BM is not particularly limited, and other forms may be used.

Also, the arrangement (for example, positions and directions) of the reference sensors B1 to BM is not particularly limited, and various forms may be used. For example, although the directions of the reference sensors B1 to BM are shown as the same direction in the example of FIG. 1, the direction of each of the reference sensors B1 to BM may be arbitrary.

In addition, the name of the reference sensor is a name for description and it may be referred to by another name such as a noise sensor or (simply) a sensor.

<Noise>

The reference sensors B1 to BM measure (detect) noise (a noise signal) superimposed on the objective signal. Also, the reference sensors B1 to BM obtain their measurement results (also referred to as noise measurement results for convenience of description).

Although a case where the reference sensors B1 to BM measure noise without measuring components of the objective signal will be described in the present embodiment, a configuration in which the components of the objective signal are included in noise measurement results of the reference sensors B1 to BM to the extent that it does not interfere with practical use may be used as another example.

Here, the noise is, for example, noise due to a signal (interference signal) other than the objective signal, and may be referred to as, for example, environmental noise.

As a specific example, when the objective signal is a magnetic signal, the noise may be a geomagnetic signal. In this case, the noise may be a magnetic signal issued from a human or another physical object (for example, a train) other than the measurement target.

Also, as a specific example, when the objective signal is an electrical signal, the noise may be electrical noise emitted from other circuits or the like in the vicinity of the measurement target 31.

In addition, the electrical signal and the magnetic signal, for example, may be collectively treated as an electromagnetic signal (electromagnetic waves).

<Types of signal sensors and types of reference sensors>

When a plurality of signal sensors A1 to AL are used, for example, they may all be the same type of sensors (sensors for measuring the same physical quantity) or different types of sensors (sensors for measuring different physical quantities) may be included.

When a plurality of reference sensors B1 to BM are used, for example, they may all be the same type of sensors (sensors for measuring the same physical quantity) or different types of sensors (sensors for measuring different physical quantities) may be included.

Also, as each of the reference sensors B1 to BM, for example, a sensor having the same type as any one of the signal sensors A1 to AL may be used or a type of sensor different from the signal sensors A1 to AL may be used.

As a specific example, when a magnetic sensor is used as the signal sensors A1 to AL, a magnetic sensor may be used as the reference sensors B1 to BM or a combination of a magnetic sensor and an acceleration sensor may be used as the reference sensors B1 to BM.

<Connection between information processing device and sensors>

In the example of FIG. 1, the signal sensors A1 to AL and the information processing device 21 are connected communicatively by wire or wireless. Also, the information processing device 21 can acquire a measurement result (detection result) of each of the signal sensors A1 to AL.

Also, each of the reference sensors B1 to BM and the information processing device 21 are communicatively connected by wire or wireless. Also, the information processing device 21 can acquire a measurement result (detection result) of each of the reference sensors B1 to BM.

In addition, in the example of FIG. 1, details of the connection between the information processing device 21 and each sensor (each of the signal sensors A1 to AL and the reference sensors B1 to BM) are omitted.

Here, a case where the information processing device 21 communicates with each sensor (each of the signal sensors A1 to AL and reference sensors B1 to BM) to acquire the measurement result of each sensor has been described in the present embodiment. However, as another example, a configuration in which the measurement result is output from a portable storage medium to the information processing device 21 after the measurement result of each sensor is stored on the storage medium and therefore the information processing device 21 acquires the measurement result may be used.

<Information processing device>

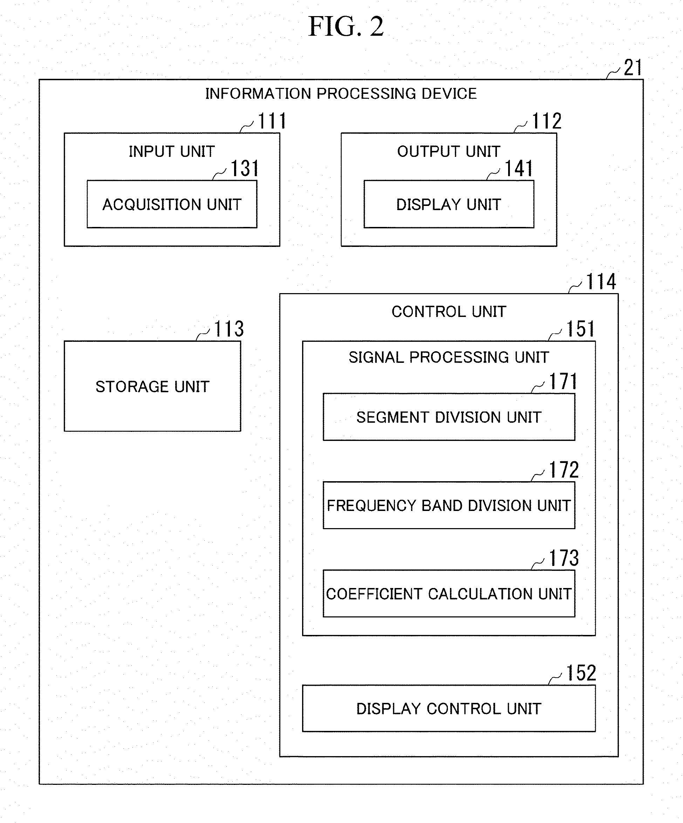

FIG. 2 is a diagram showing a schematic configuration of the information processing device 21 according to the embodiment.

The information processing device 21 includes an input unit 111, an output unit 112, a storage unit 113, and a control unit 114.

The input unit 111 includes an acquisition unit 13 1.

The output unit 112 includes a display unit 141.

The control unit 114 includes a signal processing unit 151 and a display control unit 152.

The signal processing unit 151 includes a segment division unit 171, a frequency band division unit 172, and a coefficient calculation unit 173.

The input unit 111 performs a process for an input from the outside.

In the present embodiment, the input unit 111 inputs a signal (measurement result signal) output from each sensor (each of the signal sensors A1 to AL and the reference sensors B1 to BM). As a specific example, the input unit 111 may input the signal by receiving the signal transmitted from each sensor (each of the signal sensors A1 to AL and the reference sensors B1 to BM) or may input a signal stored in a portable storage device from the storage device.

Also, the input unit 111, for example, may have a manipulation unit manipulated by a user and may input information corresponding to content of the manipulation performed by the user to the manipulation unit.

The acquisition unit 131 acquires a signal input by the input unit 111.

The acquisition unit 131 may store the acquired signal in the storage unit 113.

Here, when the signal input by the input unit 111 is an analog signal, for example, the acquisition unit 131 may have an analog-to-digital (A/D) conversion function and convert the signal from an analog signal to a digital signal.

Also, when the information processing device 21 is applied to real-time processing, the acquisition unit 131 acquires a signal in real-time. In addition, even if the information processing device 21 is not applied to real-time processing, the acquisition unit 131 may acquire a signal in real-time.

Here, a case where the acquisition unit 131 has a function of acquiring a signal measured by each of the signal sensors A1 to AL and a function of acquiring a signal measured by each of the reference sensors B1 to BM is shown in the present embodiment, but these functions may be separately provided as another example.

The output unit 112 performs a process for an output to the outside.

The display unit 141 displays and outputs information related to a signal processing result.

The display unit 141 has a screen of a liquid crystal display (LCD) or the like and displays and outputs information about the signal processing result on the screen. As another configuration example, the display unit 141 may print out information about a signal processing result on paper.

In addition, the output unit 112 may have a function of performing an output in another form such as an audio output.

The storage unit 113, for example, has a storage device such as a memory and stores information.

The storage unit 113, for example, stores information such as an input signal and a result of processing the signal.

Also, the storage unit 113, for example, stores information such as a control program.

The control unit 114 performs various types of processes and various types of control.

In the present embodiment, the control unit 114 has a processor such as a central processing unit (CPU) and the processor executes a control program stored in the storage unit 113 to perform various types of processes and various types of control.

The processor includes a calculation device that performs various types of calculation.

The signal processing unit 151 performs a predetermined process on the basis of signals of the measurement results of the signal sensors A1 to AL and signals of the measurement results of the reference sensors B1 to BM. In the present embodiment, the predetermined process is a process for removing the noise from a mixed signal of the objective signal and the noise.

Here, any degree may be used as a degree of removing the noise from the mixed signal, which is an effective degree in practical use. That is, a form in which the noise component is completely removed from the mixed signal may be used or a form in which the noise component is removed from the mixed signal to a necessary extent may be used.

The signal processing unit 151 can use the function of the segment division unit 171, the function of the frequency band division unit 172, and the function of the coefficient calculation unit 173 when performing signal processing.

In addition, in the present embodiment, for convenience of description, the function of the segment division unit 171, the function of the frequency band division unit 172, and the function of the coefficient calculation unit 173 are shown as the functions of the signal processing unit 151. However, these functions may not necessarily be clearly distinguished and these functions may be integrated without being distinguished as functions of the signal processing unit.

The segment division unit 171 divides a time period into predetermined segments.

Here, various forms may be used as the number of segments, a length (segment length) of a segment, and the like.

In addition, a length of time may be counted, for example, on the basis of the number of samples of signal data.

The frequency band division unit 172 divides a time-series signal into signals of frequency bands.

The frequency band division unit 172 may have, for example, a function of a Fourier transform. The function may be a function of a fast Fourier transform (FFT).

In the present embodiment, frequency analysis is performed on the measurement result signals of all signal sensors A1 to AL and the measurement result signals of all reference sensors B1 to BM.

The coefficient calculation unit 173 calculates a predetermined coefficient. In the present embodiment, the coefficient is a coefficient for noise removal.

The display control unit 152 displays and outputs various types of information on a screen of the display unit 141.

[Specific examples of signal processing]

In the present embodiment, the signal processing unit 151 performs analysis for a plurality of frequency ranges for a plurality of segments in time. In the analysis, for example, an adaptive noise canceling (ANC) method, which is a method of removing environmental noise, may be used.

Normally, the ANC method is executed in the entire time series without using a plurality of segments in time.

Signal data of the measurement result obtained by one or more signal sensors A1 to AL is denoted by $y(f)$. The signal data $y(f)$ is, for example, a result of performing an FFT on the measurement result.

In the present embodiment, f denotes a frequency component and (f) denotes a function of f.

Here, the signal data $y(f)$ may be, for example, signal data of a measurement result of one signal sensor Aj (j = 1 to L) of signal data obtained as a result of performing predetermined calculation on a measurement result of each of the two or more signal sensors Aj. As the predetermined operation, for example, calculation such as averaging may be used.

Signal data of a measurement result of an $i^{th}$ (i = 1 to M) reference sensor Bi is denoted by $x_i(f)$. The signal data $x_i(f)$ is, for example, a result of an FFT performed on the measurement result.

In this case, signal data $v(f)$ as a result of removing noise from the signal data $y(f)$ is expressed by Eq. (1).

Here, $w_1$ to $w_M$ denote filter coefficients for weighting and a vector having M filter coefficients as constituent elements is expressed as a vector w.

$$v(f) = y(f) - w_1 x_1(f) - w_2 x_2(f) - \cdots - w_M x_M(f) \quad \cdots \text{(1)}$$

Eq. (1) is obtained by calculating Eq. (2).

In addition, in Eq. (2), $\Sigma_{yx}$ is obtained in general calculation. $\Sigma_{xx}^{-1}$ denotes the inverse of the covariance matrix $\Sigma_{xx}$ of the measurement results of the reference sensors B1 to BM.

$$w = \begin{bmatrix} w_1 \\ w_2 \\ \vdots \\ w_M \end{bmatrix} = \Sigma_{yx} \Sigma_{xx}^{-1} \quad \cdots \text{(2)}$$

The calculation of the covariance matrix $\Sigma_{xx}$ will be described.

The measurement results of the plurality of reference sensors B1 to BM are expressed by the vector $x(f)$ expressed by Eq. (3).

$$x(f) = \begin{bmatrix} x_1(f) \\ x_2(f) \\ \vdots \\ x_M(f) \end{bmatrix} \quad \cdots \text{(3)}$$

The covariance matrix $\Sigma_{xx}$ is calculated by Eq. (4). * denotes conjugate transpose.

$$\Sigma_{xx} = \sum_{r=1}^{N}\left(x_r(f)\, x_r(f)^{*}\right) \qquad \cdots (4)$$

Here, N denotes the number of divisions (the total number of segments) when the signal data is divided into a plurality of segments.

There is a vector x(f) for each segment and there are a total of N vectors x(f) for N segments.

In order to obtain a stable value, it is necessary to set N as a certain magnitude. N affects the accuracy of calculation of the vector w of the filter coefficients.

In order to stably calculate the inverse matrix $\Sigma_{xx}^{-1}$ of the covariance matrix $\Sigma_{xx}$, about N > 3M to 10M is required in general.

In the present embodiment, regularization expressed by Expression (5) is performed to stabilize the calculation result by N. Regularization can prevent, for example, excessive estimation.

Here, y denotes a regularization parameter, $\lambda$ denotes an eigenvalue, and I denotes an identity matrix.

$$\Sigma_{xx} \rightarrow \Sigma_{xx} + \gamma\lambda\max(\Sigma_{xx})I \qquad \cdots (5)$$

<Segment division>

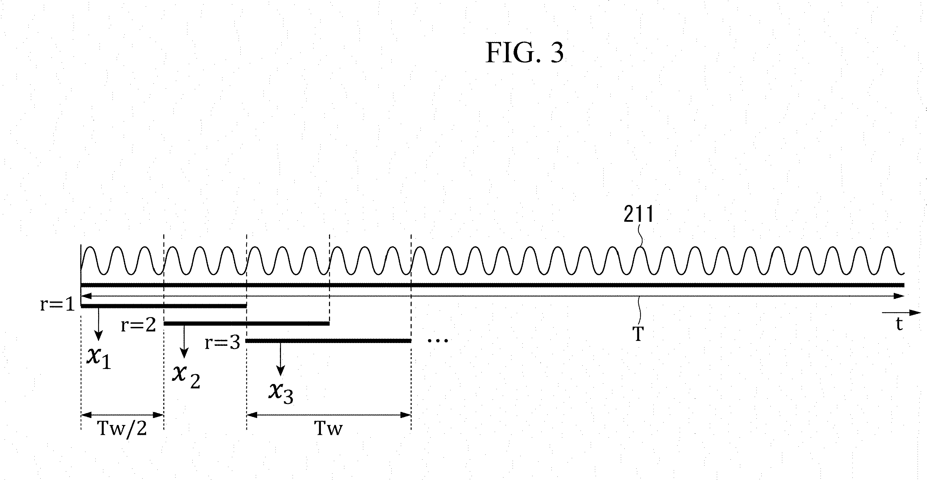

FIG. 3 is a diagram showing an example of segment division according to an embodiment.

FIG. 3 shows an axis representing time (t) as a horizontal axis.

In addition, in FIG. 3, an example of signal data 211 of a time-series signal is shown. The example of FIG. 3 shows a case where the time-series signal is a sine wave, but the present disclosure is not limited thereto.

In the example of FIG. 3, the overall length of the signal data 211 serving as the signal processing target is expressed by a period T.

Here, the signal data 211 is signal data obtained from the measurement results of the signal sensors A1 to AL. The length (signal data length) of the signal data 211 corresponds to the period (time length) of the measurement result. In addition, in the present embodiment, a sampling cycle of the signal data 211 is a predetermined cycle (for example, a certain cycle).

Also, the total number of segments in which the period T is divided into two or more is N.

N segments are $r^{th}$ (r = 1 to N) segments.

In the example of FIG. 3, the segments are arranged from the early time to the late time in order from the segment of r = 1 to the segment of r = N.

In the present embodiment, all segments have the same length (segment length). The segment length is denoted by Tw.

Also, in the example of FIG. 3, the $r^{th}$ segment and the $(r+1)^{th}$ segment, which are two adjacent segments, overlap by 1/2 of the segment length (i.e., Tw/2).

Here, the total number N of division segments is expressed as shown in Expression (6) as approximate calculation using the entire period T and the segment length Tw.

$$N \sim T/(Tw/2) \qquad \cdots (6)$$

Thus, in the present embodiment, the covariance matrix $\Sigma_{xx}$ can be calculated by dividing the signal having a total data length T into segments having a segment length Tw and calculating N vectors x(f) with data included in each segment and a noise removal result is calculated therefrom.

For example, it is necessary to increase the number of reference sensors B1 to BM to cope with various types of environmental noise. However, in the method of the present embodiment, it is possible to cope with noise by changing the segment length Tw of data division and setting N in an optimal range.

Here, in the present embodiment, a case where two adjacent segments overlap by 1/2 of the segment length is shown. However, an overlap degree may be arbitrary and, for example, a form in which two adjacent segments may come into contact with each other without overlap may be used. In addition, when two adjacent segments overlap, the possibility of loss of signal data can be prevented.

Although a case where all segments have the same segment length is described in the present embodiment, a plurality of segments may include segments having different segment lengths.

[Examples of various types of settings]

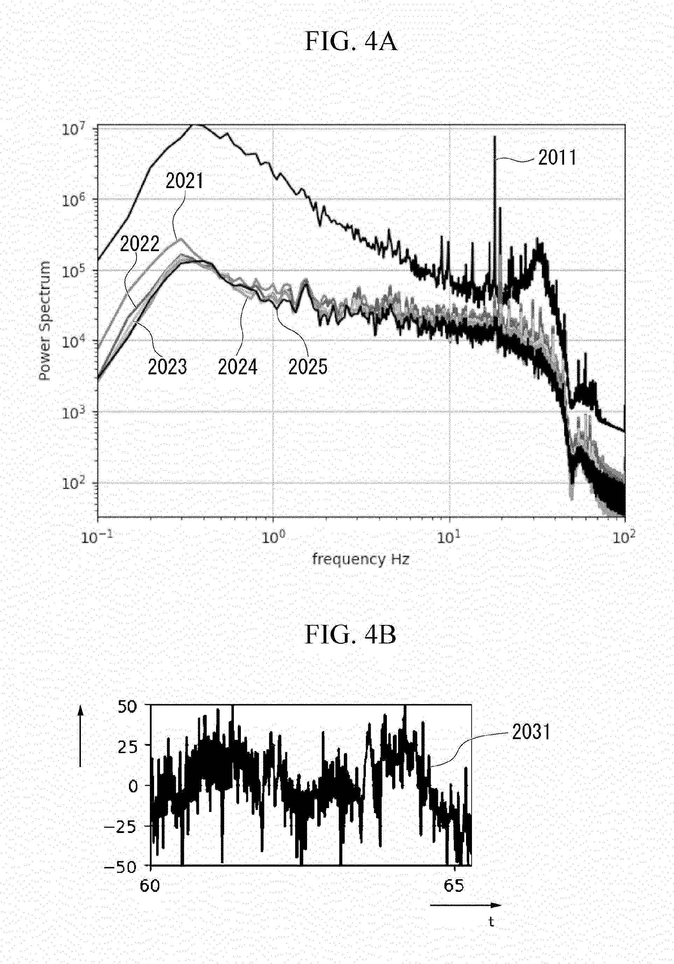

Examples of various types of settings will be described with reference to FIGS. 4A to 4H, 5A to 5F, and 6A to 6Q and FIG. 7.

In addition, each graph shown in these drawings shows a trend related to each setting and is not necessarily rigorous.

<Example of settings related to number of reference sensors>

An example of settings related to the number of reference sensors will be described with reference to FIGS. 4A to 4H.

Total data length T = 600k (k denotes $\times$ 1000). The measurement result of 120 seconds with 5k sampling is taken as an example.

Also, an example is an example of a case where the conditions of the segment length Tw = 10k of the data division interval and the regularization parameter $\gamma$ = 1e$^{-3}$ are used.

In the present embodiment, an example in which the number M of reference sensors B1 to BM is changed to 1, 2, 4, 8, and 20 will be described.

FIG. 4A is a diagram showing an example in which environmental noise removal results in the frequency domain are compared according to the embodiment.

In the example of FIG. 4A, a case where ANC of the frequency band division method in the present embodiment is used is shown.

In the graph shown in FIG. 4A, the horizontal axis represents a frequency [Hz] and the vertical axis represents an intensity of a power spectrum.

The graph shows a power spectrum 2011 of an original signal, a power spectrum 2021 in the case of M = 1, a power spectrum 2022 in the case of M = 2, a power spectrum 2023 in the case of M = 4, a power spectrum 2024 in the case of M = 8, and a power spectrum 2025 in the case of M = 20.

Here, the original signal is a signal which is measured by each of the signal sensors A1 to AL and whose noise is not removed with a signal measured by each of the reference sensors B1 to BM.

Also, a power spectrum of a case where M is any value indicates a result of removing noise with a signal measured by each of the reference sensors B1 to BM with respect to a signal measured by each of the signal sensors A1 to AL.

Signal waveforms (signal waveforms in the time domain) of a case where M is any value will be compared with reference to FIGS. 4B to 4F.

In the graphs shown in FIGS. 4B to 4F, the horizontal axis represents time (t) and the vertical axis represents signal strength. In the present example, a range of 60 to 65 [seconds] is shown as a time range.

FIG. 4B is a diagram showing an example of a signal waveform 2031 in the case of M = 1 according to the embodiment.

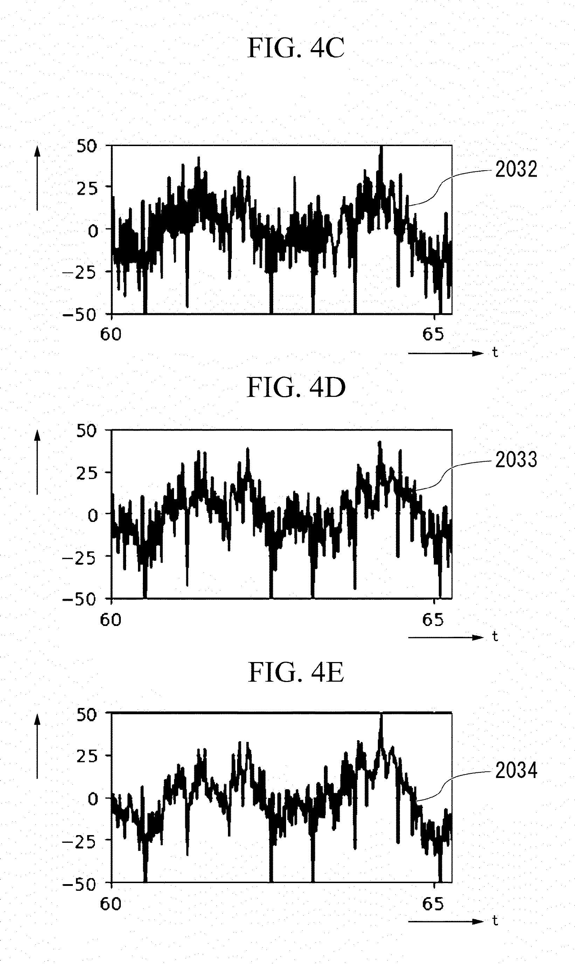

FIG. 4C is a diagram showing an example of a signal waveform 2032 in the case of M = 2 according to the embodiment.

FIG. 4D is a diagram showing an example of a signal waveform 2033 in the case of M = 4 according to the embodiment.

FIG. 4E is a diagram showing an example of a signal waveform 2034 in the case of M = 8 according to the embodiment.

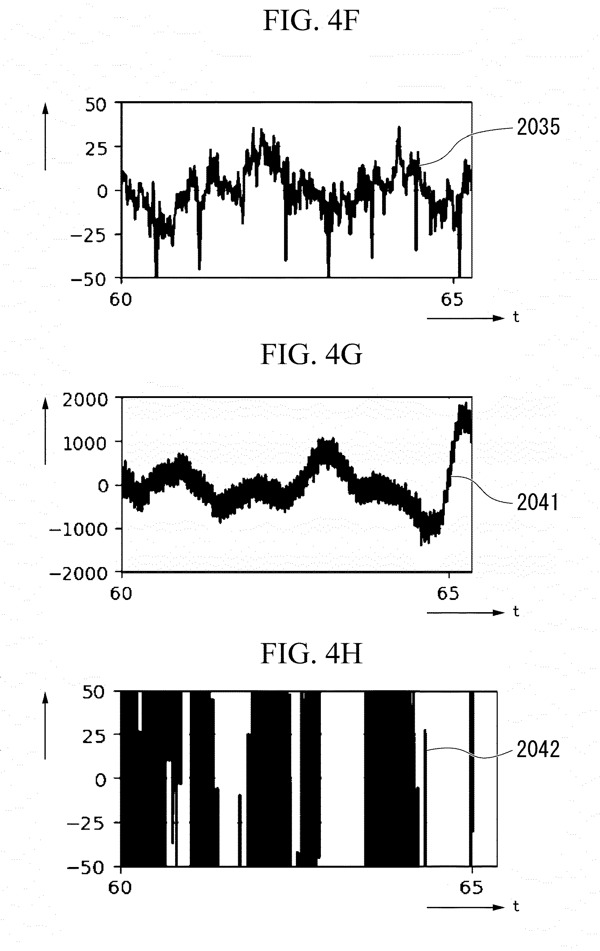

FIG. 4F is a diagram showing an example of a signal waveform 2035 in the case of M = 20 according to the embodiment.

Here, in the examples of FIGS. 4B to 4F, waveform portions protruding on the negative side (the lower side in the drawings) at predetermined intervals in time are measurement target signal portions (objective signal portions).

As shown in the examples of FIGS. 4B to 4F, the noise suppression effect increases with the increase of M in the parameter setting corresponding to the present method. For example, even if the signal waveform is viewed, the noise suppression effect increases with the increase in M.

Thereby, in the present method, the environmental noise suppression effect is increased by increasing the number of reference sensors B1 to BM under appropriate parameter settings.

Thus, the present method is a method suitable for the use of a plurality of reference sensors necessary for the removal of various types of environmental noise.

In addition, FIG. 4G is a diagram showing an example of a signal waveform 2041 of an original signal according to the embodiment.

Also, FIG. 4H is a diagram showing an example of a signal waveform 2042 of the original signal according to the embodiment in a range different from the example of FIG. 4G.

In the graphs shown in FIGS. 4G and 4H, the horizontal axis represents time and the vertical axis represents signal strength. In the present example, the time range is shown in a range of 60 to 65 [seconds] as in the case of FIGS. 4B to 4F.

As for the vertical axis, a range in which the entire waveform is displayed is used in FIG. 4G and a range similar to those of FIG. 4B to FIG. 4F is used in FIG. 4H.

<Example of settings related to division segments required for number of reference sensors>

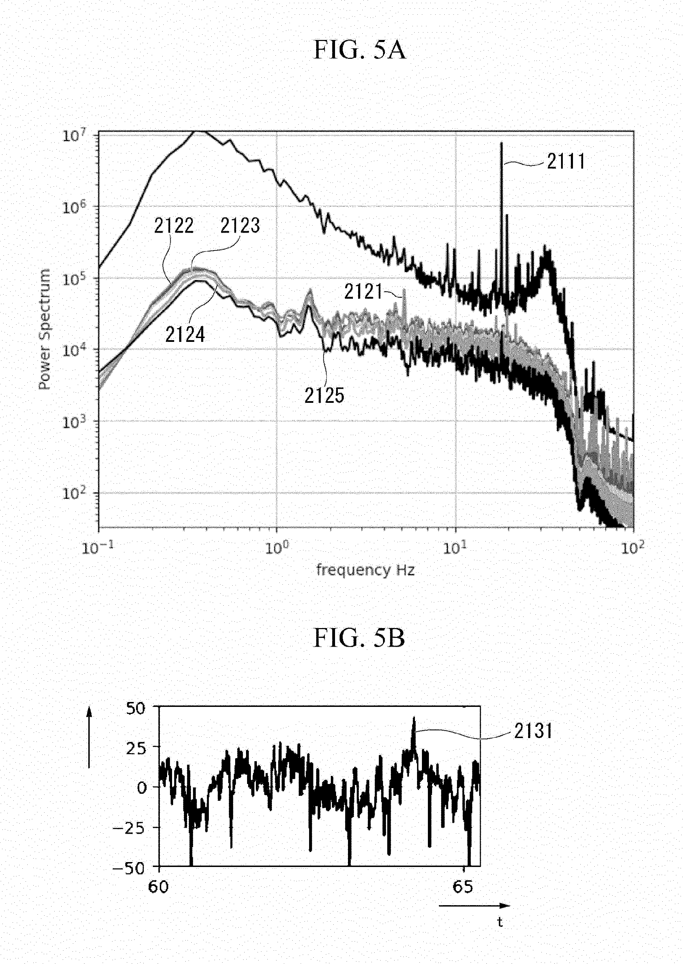

An example of settings related to division segments required for the number of reference sensors will be described with reference to FIGS. 5A to 5F.

Total data length T = 600k (k denotes ×1000). The measurement result of 120 seconds with 5k sampling is taken as an example.

Also, an example is an example of a case where the conditions of the number M = 20 of the reference sensors B1 to BM and the regularization parameter $\gamma$ = 1e$^{-6}$ are used. Also, in the present example, it is easy to ascertain a difference between segments by setting a value of the regularization parameter to a small value.

In the present embodiment, it is assumed that a value, which is about 10 times (10 times in the present example) the number M of the reference sensors B1 to BM, as the total number N of segments is required. Then, N = T/(Tw/2) and N = 10M, such that Tw = T/(5M) = 600k/(5×20) = 6k.

An example in which Tw is changed to 1k, 6k, 10k, 20k, and 40k before and after Tw = 6k will be described.

FIG. 5A is a diagram showing an example in which environmental noise removal results in the frequency domain are compared according to the embodiment.

In the example of FIG. 5A, a case where ANC of the frequency band division method in the present embodiment is used is shown.

In the graph shown in FIG. 5A, the horizontal axis represents a frequency [Hz] and the vertical axis represents an intensity of a power spectrum.

The graph shows a power spectrum 2111 of an original signal, a power spectrum 2121 in the case of Tw = 1k, a power spectrum 2122 in the case of Tw = 6 k, a power spectrum 2123 in the case of Tw = 10k, a power spectrum 2124 in the case of Tw = 20k, and a power spectrum 2125 in the case of Tw = 40k.

Here, the original signal is a signal which is measured by each of the signal sensors A1 to AL and whose noise is not removed with a signal measured by each of the reference sensors B1 to BM.

Also, a power spectrum of a case where Tw is any value indicates a result of removing noise with a signal measured by each of the reference sensors B1 to BM with respect to a signal measured by each of the signal sensors A1 to AL.

Signal waveforms (signal waveforms in the time domain) of a case where Tw is any value will be compared with reference to FIGS. 5B to 5F.

In the graphs shown in FIGS. 5B to 5F, the horizontal axis represents time (t) and the vertical axis represents signal strength. In the present example, a range of 60 to 65 [seconds] is shown as a time range.

FIG. 5B is a diagram showing an example of a signal waveform 2131 in the case of Tw = 1k according to the embodiment.

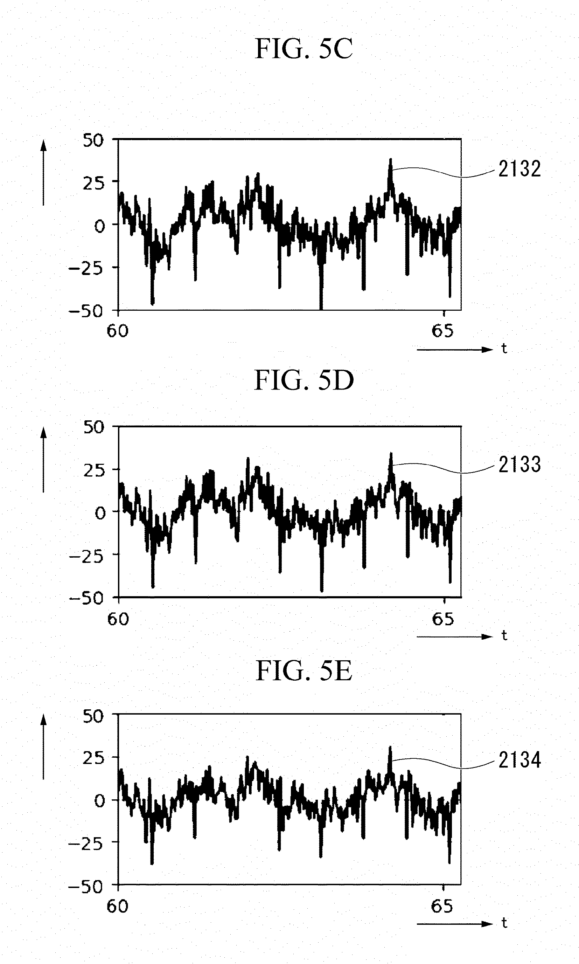

FIG. 5C is a diagram showing an example of a signal waveform 2132 in the case of Tw = 6k according to the embodiment.

FIG. 5D is a diagram showing an example of a signal waveform 2133 in the case of Tw = 10k according to the embodiment.

FIG. 5E is a diagram showing an example of a signal waveform 2134 in the case of Tw = 20k according to the embodiment.

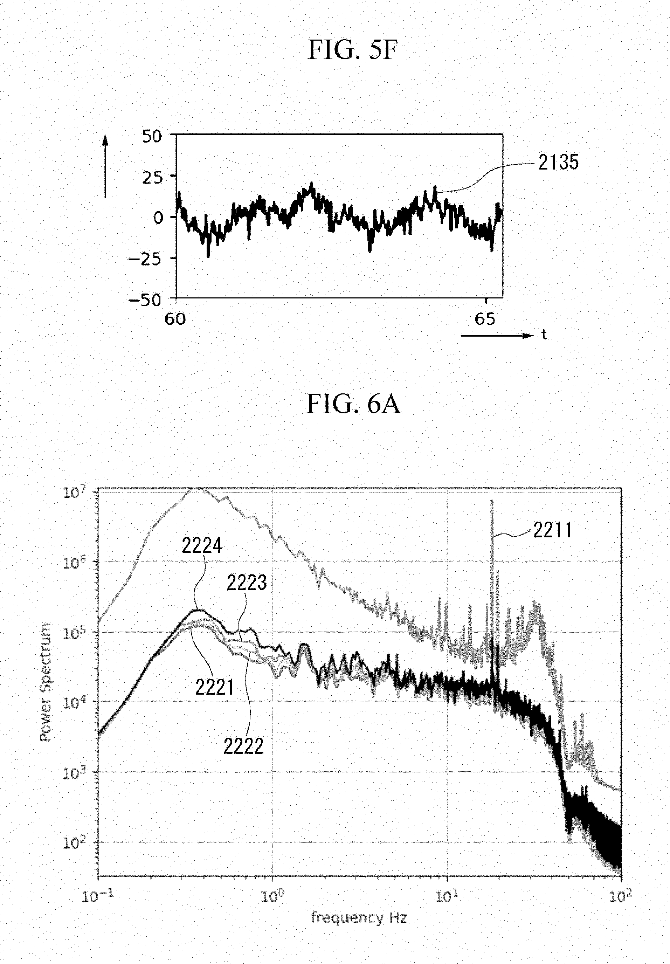

FIG. 5F is a diagram showing an example of a signal waveform 2135 in the case of Tw = 40k according to the embodiment.

Here, in the examples of FIGS. 5B to 5F, waveform portions protruding on the negative side (the lower side in the drawings) at predetermined intervals in time are measurement target signal portions (objective signal portions).

In the examples of FIGS. 5B to 5F, the noise floor is kept low in all examples.

In the examples of FIGS. 5B to 5D, the noise floor in the example of FIG. 5B is largest, the noise floor in the example in FIG. 5C is medium, and the noise floor in the example in FIG. 5D is smallest, but the waveform characteristics are maintained.

Furthermore, in the example of FIG. 5E, the noise floor is kept lower than in the examples of FIGS. 5B to 5D, but the waveform characteristics are also beginning to collapse.

Furthermore, in the example of FIG. 5F, the noise floor is kept lower than in the example of FIG. 5E, but the waveform characteristics are significantly lost.

Based on these, for example, Tw = about 6k to 10k is considered to be the optimal range under the conditions of the present example.

Thus, it is considered necessary to pay sufficient attention to a value of the segment length Tw of the division segment. For example, it is considered necessary to decide on Tw by paying sufficient attention to waveform collapse as well as a noise floor.

<Example of settings related to regularization parameter>

An example of settings related to the regularization parameter y will be described with reference to FIGS. 6A to 6Q.

Total data length T = 600k (k indicates ×1000). The measurement result of 120 seconds with 5k sampling is taken as an example.

Also, an example is an example of a case where the condition of the number M = 20 of the reference sensors B1 to BM is used.

In the present embodiment, an example in which the regularization parameter y is changed to $1e^{-5}$, $1e^{-4}$, $1e^{-3}$, and $1e^{-2}$ is shown.

Also, in the present embodiment, an example in which the segment length Tw = 1k, 10k, 20k, and 40k in the data division segment is shown.

FIG. 6A is a diagram showing an example in which environmental noise removal results in the frequency domain are compared according to the embodiment.

In the example of FIG. 6A, a case where ANC of the frequency band division method in the present embodiment is used is shown.

In the graph shown in FIG. 6A, the horizontal axis represents a frequency [Hz] and the vertical axis represents an intensity of a power spectrum.

The graph shows a power spectrum 2211 of an original signal, a power spectrum 2221 in the case of $\gamma = 1e^{-5}$, a power spectrum 2222 in the case of $\gamma = 1e^{-4}$, a power spectrum 2223 in the case of $\gamma = 1e^{-3}$, and a power spectrum 2224 in the case of $\gamma = 1e^{-2}$.

Here, the original signal is a signal which is measured by each of the signal sensors A1 to AL and whose noise is not removed with a signal measured by each of the reference sensors B1 to BM.

Also, a power spectrum of a case where y is any value indicates a result of removing noise with a signal measured by each of the reference sensors B1 to BM with respect to a signal measured by each of the signal sensors A1 to AL.

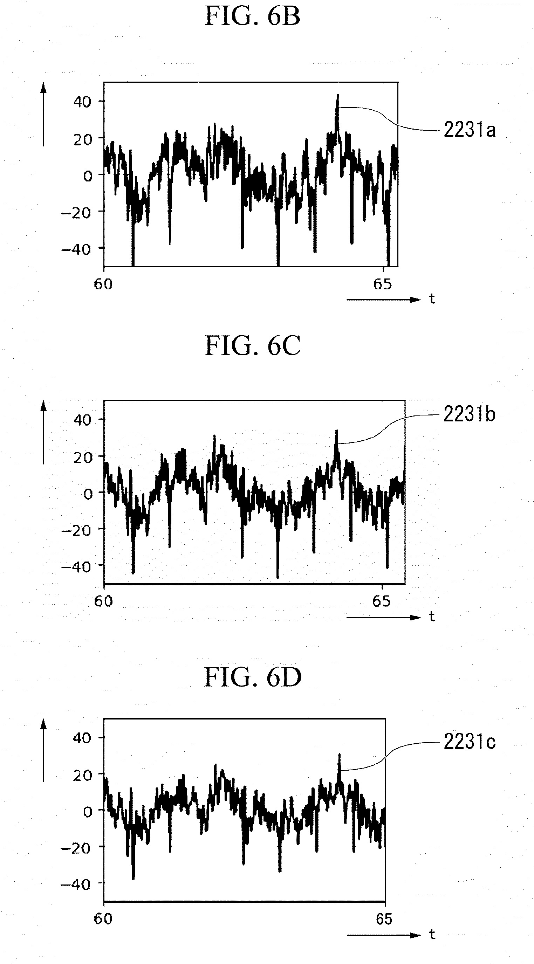

Signal waveforms (signal waveforms in the time domain) of a case where y and Tw are any values will be compared with reference to FIGS. 6B to 6Q.

In the graphs shown in FIGS. 6B to 6Q, the horizontal axis represents time (t) and the vertical axis represents signal strength. In the present example, a range of 60 to 65 [seconds] is shown as a time range.

FIG. 6B is a diagram showing an example of a signal waveform 2231a in the case of $\gamma = 1e^{-5}$ and Tw = 1k according to the embodiment.

FIG. 6C is a diagram showing an example of a signal waveform 2231b in the case of $\gamma = 1e^{-5}$ and Tw = 10k according to the embodiment.

FIG. 6D is a diagram showing an example of a signal waveform 2231c in the case of $\gamma = 1e^{-5}$ and Tw = 20k according to the embodiment.

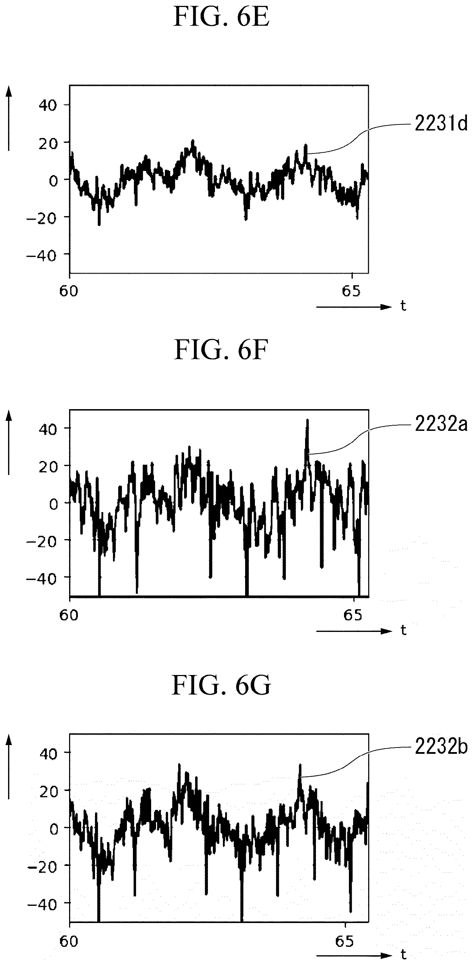

FIG. 6E is a diagram showing an example of a signal waveform 2231d in the case of $\gamma = 1e^{-5}$ and Tw = 40k according to the embodiment.

FIG. 6F is a diagram showing an example of a signal waveform 2232a in the case of $\gamma = 1e^{-4}$ and Tw = 1k according to the embodiment.

FIG. 6G is a diagram showing an example of a signal waveform 2232b in the case of $\gamma = 1e^{-4}$ and Tw = 10k according to the embodiment.

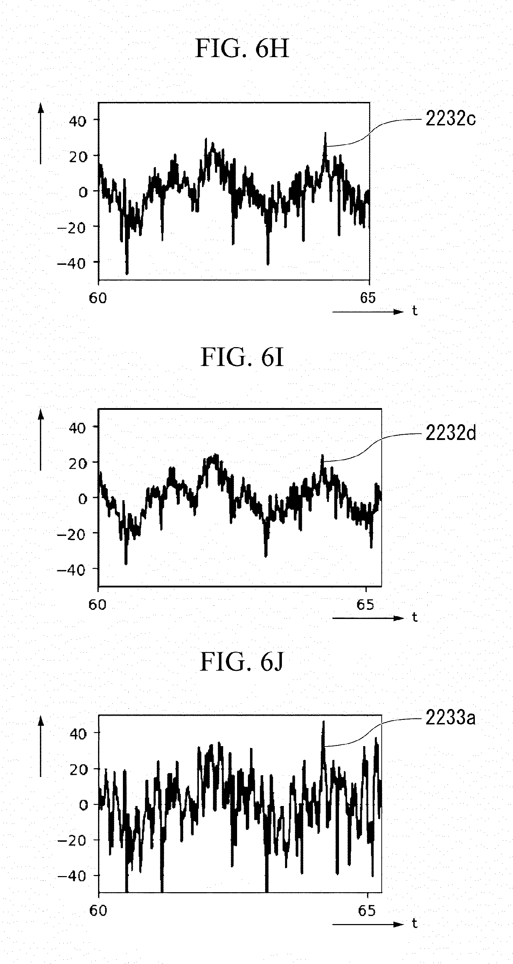

FIG. 6H is a diagram showing an example of a signal waveform 2232c in the case of $\gamma = 1e^{-4}$ and Tw = 20k according to the embodiment.

FIG. 6I is a diagram showing an example of a signal waveform 2232d in the case of $\gamma = 1e^{-4}$ and Tw = 40k according to the embodiment.

FIG. 6J is a diagram showing an example of a signal waveform 2233a in the case of $\gamma = 1e^{-3}$ and Tw = 1k according to the embodiment.

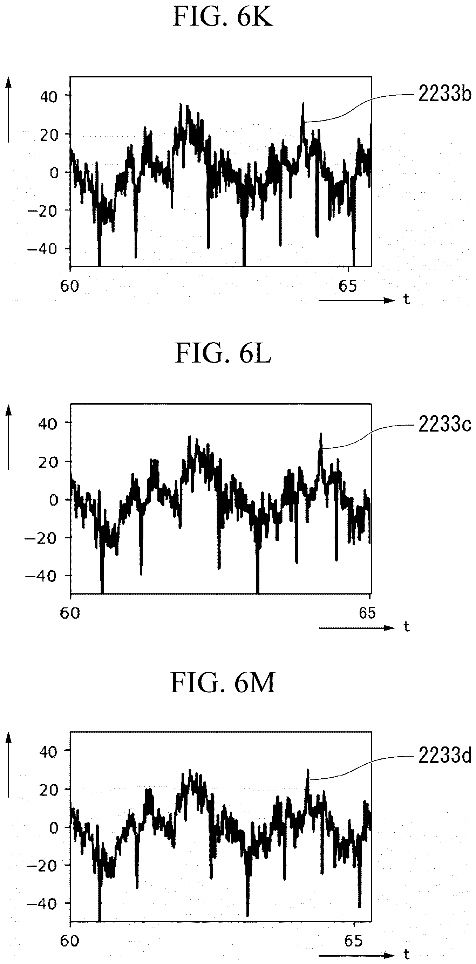

FIG. 6K is a diagram showing an example of a signal waveform 2233b in the case of $\gamma = 1e^{-3}$ and Tw = 10k according to the embodiment.

FIG. 6L is a diagram showing an example of a signal waveform 2233c in the case of $\gamma$ = 1e$^{-3}$ and Tw = 20k according to the embodiment.

FIG. 6M is a diagram showing an example of a signal waveform 2233d in the case of $\gamma$ = 1e$^{-3}$ and Tw = 40k according to the embodiment.

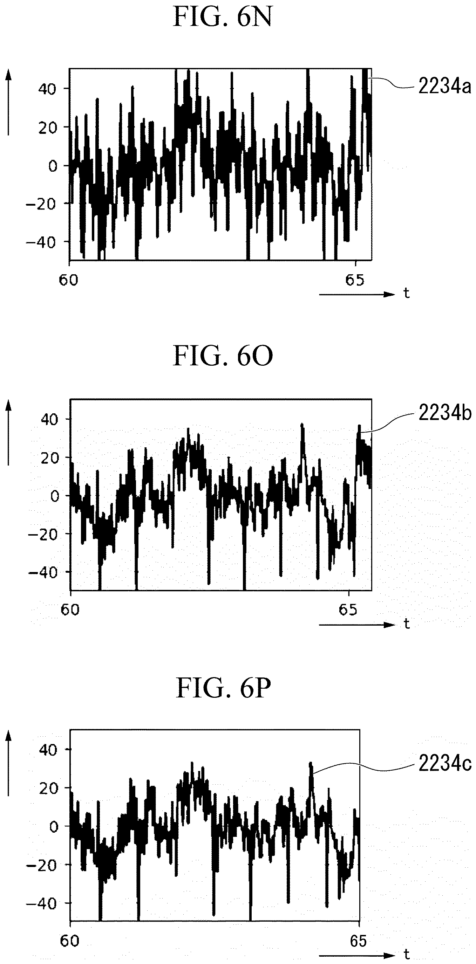

FIG. 6N is a diagram showing an example of a signal waveform 2234a in the case of $\gamma$ = 1e$^{-2}$ and Tw = 1k according to the embodiment.

FIG. 6O is a diagram showing an example of a signal waveform 2234b in the case of $\gamma$ = 1e$^{-2}$ and Tw = 10k according to the embodiment.

FIG. 6P is a diagram showing an example of a signal waveform 2234c in the case of $\gamma$ = 1e$^{-2}$ and Tw = 20k according to the embodiment.

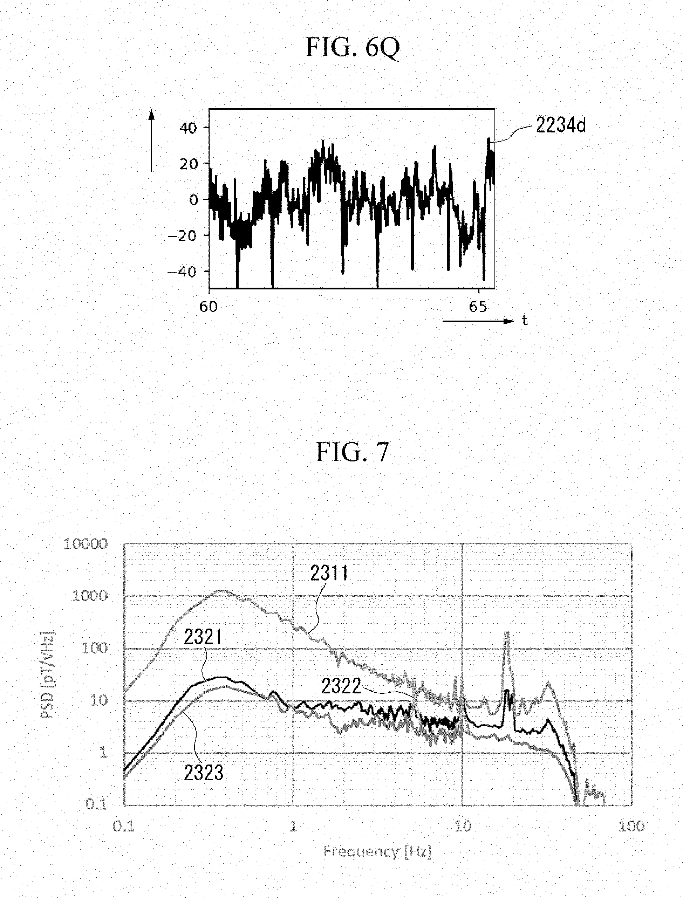

FIG. 6Q is a diagram showing an example of a signal waveform 2234d in the case of $\gamma$ = 1e$^{-2}$ and Tw = 40k according to the embodiment.

Here, in the examples of FIGS. 6B to 6Q, waveform portions protruding on the negative side (the lower side in the drawings) at predetermined intervals in time are measurement target signal portions (objective signal portions).

As shown in the examples of FIGS. 6B to 6Q, in a comparison process for signal waveforms, it is preferable to reduce the value of the regularization parameter y when the value of the segment length Tw is small. Also, when the value of the segment length Tw increases and the waveform begins to collapse, it is preferably to increase the value of the regularization parameter y.

In the present example, for example, it is considered that the optimal value is about $\gamma$ = 1e$^{-3}$.

<Example at time of setting various types of methods when plurality of reference sensors are arranged>

An example at the time of setting various types of methods when a plurality of reference sensors B1 to BM are arranged will be described with reference to FIG. 7.

Total data length T = 600k (k denotes $\times$ 1000). The measurement result of 120 seconds with 5k sampling is taken as an example.

Also, an example is an example of a case where the conditions of the segment length Tw = 10k and the regularization parameter $\gamma$ = 1e$^{-4}$ are used.

In the present example, when a plurality of reference sensors are arranged, noise densities in various types of methods are compared.

In the present example, various types of methods include ANC of a normal time-series method and ANC of a frequency band division method in the present embodiment.

In the present example, as the ANC of the frequency band division method in the present embodiment, a case where a magnetic sensor is used as the reference sensors B1 to BM, and a magnetic sensor and an acceleration sensor that are different from each other are used as the reference sensors B1 to BM will be described.

FIG. 7 is a diagram showing an example in which environmental noise removal results at noise densities are compared according to the embodiment.

In the graph shown in FIG. 7, the horizontal axis represents a frequency [Hz] and the vertical axis represents a power spectral density function (PSD) [pT/√Hz].

The graph shows characteristics 2311 of an original signal, characteristics 2321 of a case where ANC of the normal time-series method is used, characteristics 2322 of a case where the reference sensors B1 to BM are magnetic sensors and ANC of the frequency band division method according to the present embodiment is used, and characteristics 2323 of a case where the reference sensors B1 to BM are magnetic sensors and acceleration sensors and ANC of the frequency band division method according to the present embodiment is used.

Here, the original signal is a signal which is measured by each of the signal sensors A1 to AL and whose noise is not removed with a signal measured by each of the reference sensors B1 to BM.

Also, PSD characteristics indicate a result of removing noise with a signal measured by each of the reference sensors B1 to BM with respect to a signal measured by each of the signal sensors A1 to AL.

Thus, in the present method, the selection of the type of reference sensors B1 to BM and the arrangement of the reference sensors B1 to BM are considered to be important.

In addition, the case where at least an acceleration sensor (an example of a reference sensor) among the reference sensors B1 to BM has movement has been described in the present example, but the acceleration sensor may not be used when the reference sensors B1 to BM have no movement. That is, a sensor for measuring any physical quantity may be used as the reference sensors B1 to BM, but it is considered that the accuracy of noise suppression is not improved even if a sensor for measuring a physical quantity that does not occur is used.

For example, when the type of environmental noise (the type of physical quantity) is unknown, several types of sensors may be included in the reference sensors B1 to BM and the arrangement (for example, positions and directions) of the reference sensors B1 to BM may be different.

By including a plurality of types of sensors in the reference sensors B1 to BM, it is possible to acquire data of various types of environmental noise.

Also, it is possible to improve the accuracy of noise removal by considering the arrangement (for example, positions and directions) of the reference sensors B1 to BM.

[Example of processing procedure in information processing device]

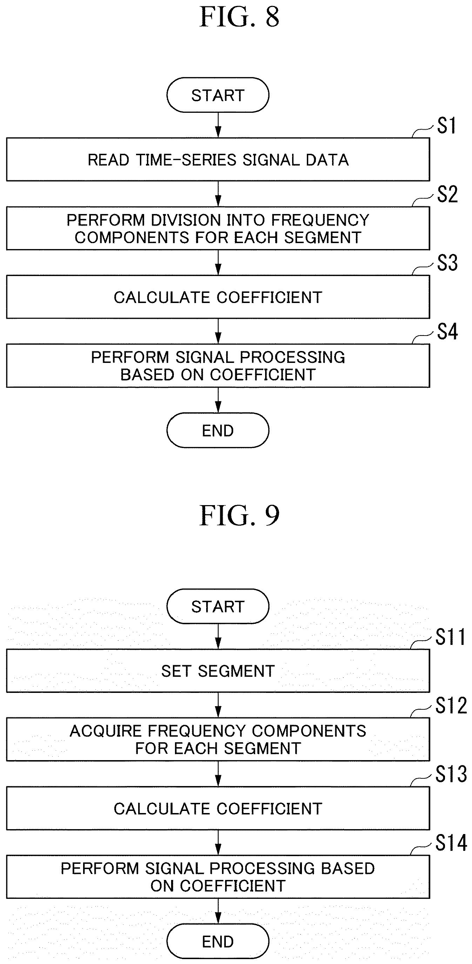

An example of a processing procedure in the information processing device 21 will be described with reference to FIGS. 8 and 9.

<Example of batch process>

FIG. 8 is a diagram showing an example of a processing procedure performed in the information processing device 21 according to the embodiment.

In the present example, for example, data of a measurement signal of a predetermined period T stored in the storage unit 113 is processed.

In the present example, a length of signal data to be processed collectively is set in the information processing device 21.

Also, in the present example, in the information processing device 21, a parameter used for calculation is set in advance. For example, the length (Tw) of the data division segment and the regularization parameter y optimal for the number M of the reference sensors B1 to BM are set.

(Step S1)

In the information processing device 21, the acquisition unit 131 reads and acquires data (signal data) of a time-series signal. Also, the process proceeds to step S2.

Here, in the present embodiment, data of a signal measured by each of the signal sensors A1 to AL and data of a signal measured by each of the reference sensors B1 to BM are used as signal data.

(Step S2)

In the information processing device 21, the signal processing unit 151 divides the signal data into frequency components for each segment with the segment division unit 171 and the frequency band division unit 172. Also, the process proceeds to step S3.

Here, in the batch process, for example, a segment division process is performed for all signal data for a predetermined period T.

(Step S3)

In the information processing device 21, the signal processing unit 151 calculates a signal processing coefficient (a weighting coefficient w in the present embodiment) with the coefficient calculation unit 173. Also, the process proceeds to step S4.

Here, the coefficient corresponds to a filter coefficient for noise removal.

(Step S4)

In the information processing device 21, the signal processing unit 151 acquires a signal from which noise has been removed by performing predetermined signal processing based on the calculated coefficient.

Also, the main flow ends.

<Example of dynamic process>

FIG. 9 is a diagram showing another example of a processing procedure performed in the information processing device 21 according to the embodiment.

In the present example, for example, data of a measurement signal is processed in real-time.

In the present example, parameters used for calculation are set in advance in the information processing device 21. For example, the length (Tw) of the data division segment and the regularization parameter $\gamma$ optimal for the number M of the reference sensors B1 to BM are set.

(Step S11)

In the information processing device 21, the signal processing unit 151 sets a segment with the segment division unit 171. Also, the process proceeds to step S12.

Here, in the present embodiment, a case where the segment is dynamically set (decided on) will be described. In addition, when the segment is set first, this setting is an initial setting.

In addition, the signal processing unit 151, for example, may use a form in which a starting position of a designated data length is shifted (slides) for each segment as a form in which the signal is dynamically processed.

(Step S12)

In the information processing device 21, the signal processing unit 151 calculates and acquires a frequency component corresponding to data (signal data) of a time-series signal for each segment with the frequency band division unit 172. Also, the process proceeds to step S 13.

Here, in the present embodiment, data of a signal measured by each of the signal sensors A1 to AL and data of a signal measured by each of the reference sensors B1 to BM are used as signal data.

Also, in a dynamic process, for example, a process is performed on signal data having a designated data length.

(Step S13)

In the information processing device 21, the signal processing unit 151 calculates a signal processing coefficient (a weighting coefficient w in the present embodiment) with the coefficient calculation unit 173. Also, the process proceeds to step S 14.

Here, the coefficient corresponds to a filter coefficient for noise removal.

(Step S14)

In the information processing device 21, the signal processing unit 151 acquires a signal from which noise has been removed by performing predetermined signal processing based on the calculated coefficient.

Also, the main flow ends.

As described above, in the measurement system 1 according to the present embodiment, the information processing device 21 can improve the accuracy of removing noise (for example, environmental noise) from a result of measuring a desired signal (objective signal) when a plurality of reference sensors B1 to BM are used.

In the information processing device 21 according to the present embodiment, when a plurality of reference sensors B1 to BM are used, it is possible to increase the accuracy of removal of various types of noise by dividing the signal data into frequency divisions for each segment.

In the information processing device 21 according to the present embodiment, for example, it is possible to increase an added value of the measurement system 1 by combining hardware for removing various types of noise and a signal processing method utilizing its characteristics.

In the information processing device 21 according to the present embodiment, in the measurement system 1 equipped with a plurality of reference sensors B1 to BM for measuring noise, it is possible to improve the accuracy of measurement using a division method in an optimal frequency range.

The measurement system 1 according to the present embodiment includes a sensor unit having one or more signal sensors A1 to AL for measuring a signal with respect to the signal to be measured in a state in which an objective signal and noise are mixed and a plurality of reference sensors B1 to BM for measuring a signal of the noise; and the signal processing unit 151 (calculation unit) configured to execute a frequency analysis process and a noise removal process to be performed on a signal obtained by the sensor unit.

In the measurement system 1 according to the present embodiment, frequency component analysis is performed on time-series signal data acquired by the signal sensors A1 to AL and time-series signal data acquired by the reference sensors B1 to BM for each predetermined division segment.

In the measurement system 1 according to the present embodiment, the division segment (Tw) is decided on the basis of the number M of the reference sensors B1 to BM and the signal data length (period T). For example, when the signal data length is uniform, the length of the division segment is shortened according to an increase in the number M of the reference sensors B1 to BM.

In the measurement system 1 according to the present embodiment, the regularization parameter y for adjusting a regularization degree is decided on the basis of the division segment (Tw) when the covariance matrix used in the calculation process of the signal processing unit 151 is regularized. Also, the regularization parameter $\gamma$ may be decided on the basis of, for example, the number M of the reference sensors B1 to BM and the division segment (Tw) thereof.

In the measurement system 1 according to the present embodiment, the reference sensors B1 to BM may include, for example, a sensor of a type identical to that of at least one of the signal sensors A1 to AL.

In the measurement system 1 according to the present embodiment, the reference sensors B1 to BM may include, for example, sensors of types different from those of the signal sensors A1 to AL.

Also, a program for implementing the function of any constituent part of any device described above may be recorded on a computer-readable recording medium and the program may be read and executed by a computer system. Also, the "computer system" used here may include an operating system (OS) or hardware such as peripheral devices. Also, the "computer-readable recording medium" refers to a flexible disk, a magneto-optical disc, a read-only memory (ROM), a portable medium such as a compact disc-ROM (CD-ROM), or a storage device such as a hard disk embedded in the computer system. Furthermore, the "computer-readable recording medium" is assumed to include a medium that holds a program for a certain period of time, such as a volatile memory inside a computer system serving as a server or a client when the program is transmitted via a network such as the Internet or a communication circuit such as a telephone circuit. For example, the volatile memory may be a random-access memory (RAM). For example, the recording medium may be a non-transitory recording medium.

Also, the above-described program may be transmitted from a computer system storing the program in a storage device or the like to another computer system via a transmission medium or by transmission waves in a transmission medium. Here, the "transmission medium" for transmitting the program refers to a medium having a function of transmitting information, as in a network such as the Internet or a communication circuit such as a telephone circuit.

Also, the above-described program may be a program for implementing some of the above-described functions. Furthermore, the above-described program may be a so-called differential file capable of implementing the above-described function in combination with a program already recorded on the computer system. The differential file may be referred to as a differential program.

Also, the function of any constituent part of any device described above may be implemented by a processor. For example, each process in the embodiment may be implemented by a processor that operates on the basis of information of a program or the like and a computer-readable recording medium that stores information of a program or the like. Here, in the processor, for example, the function of each part may be implemented by individual hardware or the function of each part may be implemented by integrated hardware. For example, the processor may include hardware and the hardware may include at least one of a circuit that processes a digital signal and a circuit that processes an analog signal. For example, the processor may be configured using one or more circuit devices or/and one or more circuit elements mounted on a circuit board. An integrated circuit (IC) or the like may be used as the circuit device and a resistor, a capacitor, or the like may be used as the circuit element.

Here, the processor may be, for example, a CPU. However, the processor is not limited to the CPU and, for example, various types of processors such as a graphics processing unit (GPU) or a digital signal processor (DSP) may be used. Also, for example, the processor may be a hardware circuit based on an application specific integrated circuit (ASIC). Also, the processor may include, for example, a plurality of CPUs, or may include a hardware circuit of a plurality of ASICs. Also, the processor may include, for example, a combination of a plurality of CPUs and a hardware circuit including a plurality of ASICs. Also, the processor may include, for example, one or more of an amplifier circuit and a filter circuit for processing an analog signal and the like.

Although embodiments of the present disclosure have been described in detail above with reference to the drawings, specific configurations are not limited to the embodiments and other designs and the like may also be included without departing from the scope of the present disclosure.

[Appendixes]

Hereinafter, (Configuration examples 1 to 8) are shown.

(Configuration example 1)

An information processing device including:

an acquisition unit configured to acquire signal measurement results of one or more signal sensors for measuring a mixed signal in which an objective signal and noise are mixed and noise measurement results of a plurality of reference sensors for measuring the noise; and
a signal processing unit configured to divide the signal measurement results and the noise measurement results acquired by the acquisition unit into a plurality of frequency bands for each of a plurality of division segments in a time domain and perform signal processing for removing the noise included in the mixed signal.

(Configuration example 2)

The information processing device according to (Configuration example 1), wherein the signal processing unit uses segments in which 112 of a segment length overlaps in two adjacent segments having the same segment length as the segments.

(Configuration example 3)

The information processing device according to (Configuration example 1 or 2),

wherein the segment is decided on the basis of the number of reference sensors and a signal data length of a signal processing target, and
wherein a length of the segment is shorter when the number of reference sensors is larger if the signal data length is uniform.

(Configuration example 4)

The information processing device according to any one of (Configuration examples 1 to 3),

wherein the signal processing unit performs the signal processing according to a calculation process using a covariance matrix, and
wherein a regularization parameter for adjusting a regularization degree when the covariance matrix is regularized is decided on the basis of the number of reference sensors and the segments.

(Configuration example 5)

The information processing device according to any one of (Configuration examples 1 to 4), wherein at least one reference sensor and at least one signal sensor are the same type of sensors.

(Configuration example 6)

The information processing device according to any one of (Configuration examples 1 to 5), wherein at least one reference sensor and at least one signal sensor are different types of sensors.
In the present embodiment, it is also possible to implement a system including the information processing device.

(Configuration example 7)

A measurement system including:

the signal processing device according to any one of (Configuration examples 1 to 6);
the signal sensors; and
the reference sensors.

In the present embodiment, it is also possible to implement a program (computer program) that is executed in a computer constituting a signal processing device.

(Configuration example 8)

A program for causing a computer to implement:

an acquisition function of acquiring signal measurement results of one or more signal sensors for measuring a mixed signal in which an objective signal and noise are mixed and noise measurement results of a plurality of reference sensors for measuring the noise; and
a signal processing function of dividing the signal measurement results and the noise measurement results acquired in the acquisition function into a plurality of frequency bands for each of a plurality of division segments in a time domain and performing signal processing for removing the noise included in the mixed signal.

EXPLANATION OF REFERENCES

1 Measurement system
11 Signal sensor arrangement unit
21 Information processing device
31 Measurement target
111 Input unit
112 Output unit
113 Storage unit
114 Control unit
131 Acquisition unit
141 Display unit
151 Signal processing unit
152 Display control unit
171 Segment division unit
172 Frequency band division unit
173 Coefficient calculation unit
211 Signal data
2011, 2021 to 2025, 2111, 2121 to 2125, 2211, 2221 to 2224 Power spectrum
2031 to 2035, 2041, 2042, 2131 to 2135, 2231a to 2231d, 2232a to 2232d, 2233a to 2233d, 2234a to 2234d Signal waveform
2311, 2321 to 2323 Characteristics
A1 to AL Signal sensor
B1 to BM Reference sensor

**Claims**

1. An information processing device comprising:

   an acquisition unit configured to acquire signal measurement results of one or more signal sensors for measuring a mixed signal in which an objective signal and noise are mixed and noise measurement results of a plurality of reference sensors for measuring the noise; and
   a signal processing unit configured to divide the signal measurement results and the noise measurement results acquired by the acquisition unit into a plurality of frequency bands for each of a plurality of division segments in a time domain and perform signal processing for removing the noise included in the mixed signal.

2. The information processing device according to claim 1, wherein the signal processing unit uses segments in which 1/2 of a segment length overlaps in two adjacent segments having the same segment length as the segments.

3. The information processing device according to claim 1 or 2,

   wherein the segment is decided on the basis of the number of reference sensors and a signal data length of a signal processing target, and
   wherein a length of the segment is shorter when the number of reference sensors is larger if the signal data length is uniform.

4. The information processing device according to any one of claims 1 to 3,

   wherein the signal processing unit performs the signal processing according to a calculation process using a covariance matrix, and
   wherein a regularization parameter for adjusting a regularization degree when the covariance matrix is regularized is decided on the basis of the number of reference sensors and the segments.

5. The information processing device according to any one of claims 1 to 4, wherein at least one reference sensor and at least one signal sensor are the same type of sensors.

6.  The information processing device according to any one of claims 1 to 5, wherein at least one reference sensor and at least one signal sensor are different types of sensors.

7.  A measurement system comprising:

    the signal processing device according to any one of claims 1 to 6;
    the signal sensors; and
    the reference sensors.

8.  A program for causing a computer to implement:

    an acquisition function of acquiring signal measurement results of one or more signal sensors for measuring a mixed signal in which an objective signal and noise are mixed and noise measurement results of a plurality of reference sensors for measuring the noise; and
    a signal processing function of dividing the signal measurement results and the noise measurement results acquired in the acquisition function into a plurality of frequency bands for each of a plurality of division segments in a time domain and performing signal processing for removing the noise included in the mixed signal.

## FIG. 1

# FIG. 2

INFORMATION PROCESSING DEVICE　21

INPUT UNIT　111
ACQUISITION UNIT　131

OUTPUT UNIT　112
DISPLAY UNIT　141

STORAGE UNIT　113

CONTROL UNIT　114

SIGNAL PROCESSING UNIT　151

SEGMENT DIVISION UNIT　171

FREQUENCY BAND DIVISION UNIT　172

COEFFICIENT CALCULATION UNIT　173

DISPLAY CONTROL UNIT　152

FIG. 3

## FIG. 4A

## FIG. 4B

# FIG. 4C

# FIG. 4D

# FIG. 4E

## FIG. 4F

## FIG. 4G

## FIG. 4H

# FIG. 5A

# FIG. 5B

# FIG. 5C

# FIG. 5D

# FIG. 5E

# FIG. 5F

# FIG. 6A

## FIG. 6B

## FIG. 6C

## FIG. 6D

## FIG. 6E

## FIG. 6F

## FIG. 6G

## FIG. 6H

2232c

## FIG. 6I

2232d

## FIG. 6J

2233a

## FIG. 6K

2233b

## FIG. 6L

2233c

## FIG. 6M

2233d

## FIG. 6N

2234a

## FIG. 6O

2234b

## FIG. 6P

2234c

# FIG. 6Q

# FIG. 7

# FIG. 8

```
          ┌─────────────┐
          │   START     │
          └──────┬──────┘
                 │
                 ▼                              ⌐S1
    ┌──────────────────────────────────────┐
    │      READ TIME-SERIES SIGNAL DATA     │
    └──────────────────┬───────────────────┘
                       │
                       ▼                        ⌐S2
    ┌──────────────────────────────────────┐
    │    PERFORM DIVISION INTO FREQUENCY    │
    │     COMPONENTS FOR EACH SEGMENT       │
    └──────────────────┬───────────────────┘
                       │
                       ▼                        ⌐S3
    ┌──────────────────────────────────────┐
    │         CALCULATE COEFFICIENT         │
    └──────────────────┬───────────────────┘
                       │
                       ▼                        ⌐S4
    ┌──────────────────────────────────────┐
    │       PERFORM SIGNAL PROCESSING       │
    │        BASED ON COEFFICIENT           │
    └──────────────────┬───────────────────┘
                       │
                       ▼
               ┌─────────────┐
               │     END     │
               └─────────────┘
```

# FIG. 9

```
          ┌─────────────┐
          │   START     │
          └──────┬──────┘
                 │
                 ▼                              ⌐S11
    ┌──────────────────────────────────────┐
    │            SET SEGMENT                │
    └──────────────────┬───────────────────┘
                       │
                       ▼                        ⌐S12
    ┌──────────────────────────────────────┐
    │     ACQUIRE FREQUENCY COMPONENTS      │
    │          FOR EACH SEGMENT             │
    └──────────────────┬───────────────────┘
                       │
                       ▼                        ⌐S13
    ┌──────────────────────────────────────┐
    │         CALCULATE COEFFICIENT         │
    └──────────────────┬───────────────────┘
                       │
                       ▼                        ⌐S14
    ┌──────────────────────────────────────┐
    │    PERFORM SIGNAL PROCESSING BASED    │
    │           ON COEFFICIENT              │
    └──────────────────┬───────────────────┘
                       │
                       ▼
               ┌─────────────┐
               │     END     │
               └─────────────┘
```

Europäisches
Patentamt
European
Patent Office
Office européen
des brevets

# EUROPEAN SEARCH REPORT

Application Number

EP 24 15 8581

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BICK ET AL: "SQUID gradiometry for magnetocardiography using different noise cancellation techniques", IEEE TRANSACTIONS ON APPLIED SUPERCONDUCTIVITY, IEEE, USA, vol. 11, no. 1, 1 March 2001 (2001-03-01), pages 673-676, XP011141886, ISSN: 1051-8223, DOI: 10.1109/77.919434 | 1-3,5-8 | INV. G01R33/00 ADD. G01R33/025 |
| Y | * section II. A. * | 2,4 | |
| X | US 2017/108569 A1 (HARVEY PAUL ROYSTON [NL] ET AL) 20 April 2017 (2017-04-20) | 1,3,5-8 | |
| Y | * paragraphs [0025], [0026], [0034], [0041] - [0042], [0072] - [0080]; figures 1, 4 * | 4 | |
| X | US 2011/181290 A1 (KUZMIN PETR VALENTINOVICH [CA] ET AL) 28 July 2011 (2011-07-28) | 1-4,6-8 | |
| Y | * paragraphs [0056] - [0058]; figures 5A, 5B * | 2,4 | |
| Y | WO 2022/240346 A1 (HEAREZANZ AB [SE]) 17 November 2022 (2022-11-17) * page 12 * | 2 | TECHNICAL FIELDS SEARCHED (IPC) G01R |
| A | JP 2022 146407 A (TDK CORP) 5 October 2022 (2022-10-05) * the whole document * | 1-8 | |
| A | US 2019/066654 A1 (DICKINS GLENN N [AU] ET AL) 28 February 2019 (2019-02-28) * paragraphs [0022] - [0024], [0070] - [0072]; figures 1-3 * | 1-8 | |
| A,D | JP 2019 010483 A (HITACHI HIGH TECH CORP) 24 January 2019 (2019-01-24) * the whole document * | 1-8 | |

The present search report has been drawn up for all claims

| Place of search | Date of completion of the search | Examiner |
|---|---|---|
| Munich | 5 July 2024 | Philipp, Peter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 8581

This annex lists the patent family members relating to the patent documents cited in the above-mentioned European search report.
The members are as contained in the European Patent Office EDP file on
The European Patent Office is in no way liable for these particulars which are merely given for the purpose of information.

05-07-2024

| Patent document cited in search report | | Publication date | Patent family member(s) | | Publication date |
|---|---|---|---|---|---|
| US 2017108569 | A1 | 20-04-2017 | CN | 106164694 A | 23-11-2016 |
| | | | EP | 3126861 A1 | 08-02-2017 |
| | | | JP | 6688740 B2 | 28-04-2020 |
| | | | JP | 2017515532 A | 15-06-2017 |
| | | | US | 2017108569 A1 | 20-04-2017 |
| | | | WO | 2015150236 A1 | 08-10-2015 |
| US 2011181290 | A1 | 28-07-2011 | AU | 2010324493 A1 | 07-06-2012 |
| | | | BR | 112012012552 A2 | 18-09-2018 |
| | | | CA | 2781782 A1 | 03-06-2011 |
| | | | CN | 102763007 A | 31-10-2012 |
| | | | EP | 2504723 A1 | 03-10-2012 |
| | | | RU | 2012126003 A | 10-01-2014 |
| | | | US | 2011181290 A1 | 28-07-2011 |
| | | | WO | 2011063510 A1 | 03-06-2011 |
| | | | ZA | 201203936 B | 28-08-2013 |
| WO 2022240346 | A1 | 17-11-2022 | CN | 117321681 A | 29-12-2023 |
| | | | EP | 4115413 A1 | 11-01-2023 |
| | | | JP | 2024517721 A | 23-04-2024 |
| | | | KR | 20240007168 A | 16-01-2024 |
| | | | SE | 2150611 A1 | 13-11-2022 |
| | | | US | 2024221769 A1 | 04-07-2024 |
| | | | WO | 2022240346 A1 | 17-11-2022 |
| JP 2022146407 | A | 05-10-2022 | NONE | | |
| US 2019066654 | A1 | 28-02-2019 | NONE | | |
| JP 2019010483 | A | 24-01-2019 | JP | 6890484 B2 | 18-06-2021 |
| | | | JP | 2019010483 A | 24-01-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023027555 A
- JP 2019010483 A